(19) Europäisches Patentamt
European Patent Office
Office européen des brevets

(11) **EP 3 207 778 B1**

(12) **EUROPÄISCHE PATENTSCHRIFT**

(45) Veröffentlichungstag und Bekanntmachung des Hinweises auf die Patenterteilung:
**08.09.2021 Patentblatt 2021/36**

(21) Anmeldenummer: **15797044.3**

(22) Anmeldetag: **12.11.2015**

(51) Int Cl.:
***H05K 13/08*** *(2006.01)*

(86) Internationale Anmeldenummer:
**PCT/EP2015/076381**

(87) Internationale Veröffentlichungsnummer:
**WO 2016/091527 (16.06.2016 Gazette 2016/24)**

(54) **VERFAHREN UND SYSTEM ZUR BESTÜCKUNG VON LEITERPLATTEN SOWIE COMPUTERPROGRAMMPRODUKT ZUR DURCHFÜHRUNG DES VERFAHRENS**

METHOD AND SYSTEM FOR POPULATING PRINTED CIRCUIT BOARDS AND COMPUTER PROGRAM PRODUCT FOR CARRYING OUT THE METHOD

PROCÉDÉ ET SYSTEME D'ÉQUIPEMENT DE CARTES DE CIRCUIT IMPRIMÉ ET PRODUIT PROGRAMME D'ORDINATEUR POUR METTRE EN UVRE LE PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.12.2014 DE 102014225713**

(43) Veröffentlichungstag der Anmeldung:
**23.08.2017 Patentblatt 2017/34**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**EP-A1- 0 478 360          WO-A1-2014/005744
DE-B3-102009 013 353**

## Beschreibung

Die vorliegende Erfindung betrifft ein Verfahren und ein System zum Zuordnen von Leiterplattentypen. Dabei wird eine Bestückungslinie vorausgesetzt, die dazu eingerichtet ist, Leiterplatten mit Bauelementen zu bestücken.

Eine elektronische Baugruppe umfasst eine Leiterplatte und Bauelemente, die auf ihr mechanisch und elektrisch befestigt sind. Zur Herstellung der Leiterplatte werden die Bauelemente mittels eines Bestückungsautomaten (pick-and-place) auf der Leiterplatte abgelegt und anschließend in einem Reflow-Ofen mit ihr verlötet. Mehrere Bestückungsautomaten können auf einer Bestückungslinie nacheinander durchlaufen werden. Zur Herstellung vieler Leiterplatten kann ein Bestückungssystem verwendet werden, das mehrere Bestückungslinien umfasst.

Eine Zusammensetzung von Bauelementetypen am Bestückungsautomat wird Rüstung genannt. Mit einer Rüstung kann eine Menge von unterschiedlichen Leiterplatten gefertigt werden, die Rüstfamilie genannt wird. Üblicherweise sollen jedoch Leiterplatten von mehr unterschiedlichen Leiterplattentypen gefertigt werden, als mittels einer Rüstung möglich ist, sodass die Rüstung während der Produktion geändert werden muss.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementetypen ist jedoch aufwändig. Die Rüstungen werden daher oft in Festrüstungen und Variantenrüstungen unterschieden, wobei ein Festrüstungstisch dazu vorgesehen ist, seine Zusammensetzung von Bauelementetypen über einen vorbestimmten Planungshorizont zu behalten, während ein Variantenrüsttisch voraussichtlich innerhalb des Planungshorizonts umgerüstet wird.

DE 10 2012 220 904 A1 betrifft ein Verfahren zur Bestimmung einer möglichst vorteilhaften Festrüstung für eine Bestückungslinie.

EP 0 478 360 A1 betrifft die Zuordnung von Bauelementetypen zu Rüstungen, die an einer Bestückungslinie angebracht werden können, um damit Leiterplatten zu bestücken.

Werden mehrere Rüstungen nacheinander an einer Bestückungslinie verwendet, so kann ein konstanter Rüsttisch gebildet werden, der bei einem Rüstwechsel an der Bestückungslinie verbleibt und dessen Zusammensetzung von Bauelementetypen dabei auch nicht verändert wird. DE 10 2009 013 353 zeigt ein Verfahren, Rüstungen bzw. Rüstfamilien unter Bildung von konstanten Rüsttischen zu finden.

Werden erst konstante Rüsttische gebildet, so können nur suboptimale oder unter Umständen sogar nur sehr schlechte Festrüstungen gebildet werden, die nur sehr selten eingesetzt werden können. Werden hingegen zuerst Festrüstungen gebildet und dann deren Bauelementetypen an Rüsttische zugeordnet, so können üblicherweise nur sehr wenige oder gar keine konstanten Rüsttische gebildet werden.

Der Erfindung liegt daher die Aufgabe zu Grunde, ein verbessertes Verfahren und ein System zur Bestückung von Leiterplatten anzugeben, die eine effizientere Bestückung einer Bestückungslinie erlaubt. Die Erfindung löst diese Aufgabe mittels der Gegenstände der unabhängigen Ansprüche. Unteransprüche geben bevorzugte Ausführungsformen wieder.

Zum Bestücken von Leiterplatten mittels einer Bestückungslinie sind Rüstfamilien mit zugehörigen Rüstungen vorgesehen. Jeder Rüstfamilie ist eine Anzahl Leiterplattentypen und jeder zugeordneten Rüstung eine Anzahl Bauelementetypen zugeordnet, sodass eine Leiterplatte eines Leiterplattentyps einer Rüstfamilie mittels Bauelementen der Bauelementetypen der Rüstung an der Bestückungslinie bestückt werden kann. Vorräte von Bauelementen der Bauelementtypen einer Rüstung können mittels Rüsttischen an der Bestückungslinie bereitgestellt werden. Ein Verfahren zum Zuordnen der Leiterplattentypen umfasst Schritte des Erfassens von Leiterplattentypen, von denen Leiterplatten mit Bauelementen zugeordneter Bauelementetypen bestückt werden sollen, des Zuordnens von erfassten Leiterplattentypen zu einer vorbestimmten Anzahl von Festrüstungs-Rüstfamilien, wobei eine Festrüstung dazu vorgesehen ist, auf einer Anzahl Wechseltische über einen vorbestimmten Planungshorizont unverändert gerüstet zu bleiben, und des Optimierens der Zuordnung bezüglich eines vorbestimmten Kriteriums. Dabei erfolgt das Optimieren derart, dass die Bauelementtypen der Festrüstungen aller Festrüstungs-Rüstfamilien so auf Rüsttische aufgeteilt werden können, dass eine wenigstens eins betragende Anzahl konstanter Rüsttische über alle Rüstungen an der Bestückungslinie verbleiben kann. Anschließend kann eine der Festrüstungen an der Bestückungslinie bereitgestellt werden. Leiterplatten eines Leiterplattentyps, der der Rüstfamilie der Rüstung zugeordnet ist, können auf der Bestückungslinie bestückt werden.

Auf diese Weise können unterschiedliche Zielkriterien gleichzeitig behandelt werden, nämlich das Optimieren beispielsweise bezüglich eines Bestückungsvolumens oder einer Auftragszahl und das Bilden eines oder mehrerer konstanter Rüsttische. Eine einseitige Optimierung bezüglich nur eines der Zielkriterien kann dadurch vermieden werden, sodass das Gesamtergebnis verbessert sein kann. Die Bestückungslinie kann dadurch mit verbesserter Effizienz betrieben werden und Kosten für ihren Betrieb können verringert sein.

Jedem Leiterplattentyp kann eine Auftragszahl zugeordnet sein, die angibt, wie viele Bestückungsaufträge für den Leiterplattentyp in einem vorbestimmten Planungshorizont vorliegen. Dabei kann das Kriterium umfassen, die Summe der Auftragszahlen möglichst zu maximieren. Jedem Bestückungsauftrag kann eine Stückzahl von Leiterplatten des Leiterplattentyps zugeordnet sein.

Dadurch kann ein effizientes Zielkriterium verfolgt werden, während gleichzeig der konstante Rüsttisch gebildet wird.

In einem nicht der beanspruchten Erfindung entsprechenden Verfahren kann jedem Leiterplattentyp eine Stückzahl von zu bestückenden Leiterplatten zugeordnet sein, wobei das Kriterium umfasst, die Summe der Stückzahlen, die mittels aller Festrüstungen auf der Bestückungslinie bestückt werden können, möglichst zu maximieren.

Entsprechend der beanspruchten Erfindung sind jedem Leiterplattentyp eine Stückzahl von zu bestückenden Leiterplatten und eine Bestückzeit, die zur Bestückung einer Leiterplatte des Leiterplattentyps auf der Bestückungslinie erforderlich ist, zugeordnet. Dabei umfasst das Kriterium, die Bestückzeit, die zur Bestückung aller Leiterplatten aller zugeordneten Leiterplattentypen erforderlich ist möglichst zu maximieren.

Die Bauelementetypen der Festrüstungen bleiben innerhalb eines vorbestimmten Planungshorizonts unverändert. Das Verfahren kann so eine Aufteilung der Leiterplattentypen in die Festrüstungsfamilien und einen variablen Rüstanteil sicherstellen. Der vorbestimmte Planungshorizont kann im Bereich von Monaten liegen, beispielsweise ca. 6 bis 12 Monaten. Leiterplattentypen, die keiner Festrüstungsfamilie zugeordnet sind, können mittels eines weiteren Verfahrens behandelt werden. Dazu können sie beispielsweise temporär einer variablen Rüstfamilie zugeordnet werden, die aus dem variablen Rüstanteil gebildet werden kann.

Es ist besonders bevorzugt, dass die Zuordnung mittels Gemischt Ganzzahliger Programmierung erfolgt. Die Gemischt Ganzzahlige Programmierung stellt einen globalen Optimierungsansatz dar, der leicht erweiterbar ist und für den kommerzielle Lösungsverfahren bzw. Lösungsvorrichtungen erhältlich sind. Mittels Gemischt Ganzzahliger Programmierung können in einer Vielzahl möglicher Lösungen globale Maxima gefunden werden, sodass eine besonders gute Optimierung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Vorteilhafterweise ist bei der Gemischt Ganzzahligen Programmierung für eine bestimmte Zuordnung jeweils bekannt, wie hoch die Zuordnungsgüte im Vergleich zu einer maximal erreichbaren Zuordnungsgüte ist. Ein Unterschied zwischen diesen beiden Kennzahlen wird auch "Gap" genannt. Dadurch kann die Optimierung bevorzugterweise dann abgebrochen werden, wenn eine vorbestimmte Zuordnungsgüte erreicht ist oder wenn der Gap ausreichend klein ist. Alternativ oder zusätzlich kann das Optimieren dann abgebrochen werden, wenn während einer vorbestimmten Bearbeitungszeit keine Zuordnung gefunden werden kann, deren Zuordnungsgüte die vorgegebenen Kriterien erfüllt. Dadurch kann verhindert werden, dass eine zu hoch gewählte Zuordnungsgüte oder ein zu klein gewählter Gap die Bestimmung einer Zuordnung in angemessener Zeit verhindert.

Weiterhin umfasst das Verfahren ferner den Schritt des Aufteilens der Bauelementetypen der Festrüstungen auf die Rüsttische und den wenigstens einen konstanten Rüsttisch derart, dass der wenigstens eine konstante Rüsttisch über alle Festrüstungen an der Bestückungslinie verbleiben kann. Anders ausgedrückt unterscheidet sich ein konstanter Rüsttisch von einem normalen Rüsttisch dadurch, dass er bei einem Rüstungswechsel, insbesondere von einer Festrüstung auf eine andere Festrüstung, unverändert an der Bestückungslinie angebracht bleibt.

Statt nur eines konstanten Rüsttischs können auch mehrere konstante Rüsttische gebildet werden. In einer bevorzugten Ausführungsform des Verfahrens erfolgt die Optimierung derart, dass die Bauelementetypen der Festrüstungen derart auf Rüsttische aufgeteilt werden können, dass eine vorbestimmte Anzahl konstanter Rüsttische über alle Festrüstungen an der Bestückungslinie verbleiben kann. Die vorbestimmte Anzahl kann bevorzugterweise für die Optimierung vorgegeben werden. Damit kann ein wichtiger praxisrelevanter Produktionsparameter für die Optimierung genutzt werden.

In einer Ausführungsform des Verfahrens sind genau zwei Festrüstungen vorgesehen. Die Optimierung kann, beispielsweise durch entsprechende Formulierung von Randbedingungen, durch diese Einschränkung bedeutend beschleunigt werden. In der Praxis ist eine Konstellation mit genau zwei Festrüstungen häufig anzutreffen.

Es ist weiterhin bevorzugt, dass die Zuordnung derart erfolgt, dass ein Platzverbrauch der Bauelementetypen, die im Rahmen der bestimmten Rüstung einer Bestückungslinie zugeordnet sind, einen vorbestimmten Anteil eines zur Verfügung stehenden Platzes einhält. Dieser Platz wird üblicherweise in Spuren ausgedrückt, wobei eine Spur beispielsweise 8 mm breit sein kann. Ein Rüsttisch umfasst beispielsweise 40 Spuren und ein Bestückungsautomat bietet Platz für 2 Rüsttische. In diesem Beispiel beträgt der zur Verfügung stehende Platz insgesamt 640 mm, wobei die Grenzen der Rüsttische berücksichtigt werden müssen. Es kann beispielsweise gefordert sein, dass die bestimmte Rüstung nicht mehr als ca. 90% dieses Platzes einnimmt, um die Flexibilität zu haben zusätzliche Bauelementtypen für Eilaufträge in der Rüstung unterbringen zu können.

Ein Computerprogrammprodukt umfasst Programmcodemittel zur Durchführung des beschriebenen Verfahrens, wenn es auf einer Verarbeitungseinrichtung abläuft oder auf einem computerlesbaren Medium gespeichert ist. Die Verarbeitungseinrichtung kann insbesondere einen programmierbaren Mikrocomputer umfassen.

Ein System zur Bestückung von Leiterplatten umfasst eine Bestückungslinie und eine Verarbeitungseinrichtung zur Durchführung des oben angegebenen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1 ein Bestückungssystem;

Fig. 2 eine Veranschaulichung von Rüstfamilien an einer Bestückungslinie von Fig. 1 und

Fig. 3 Rüstungen an einem Bestückungsautomaten

darstellt.

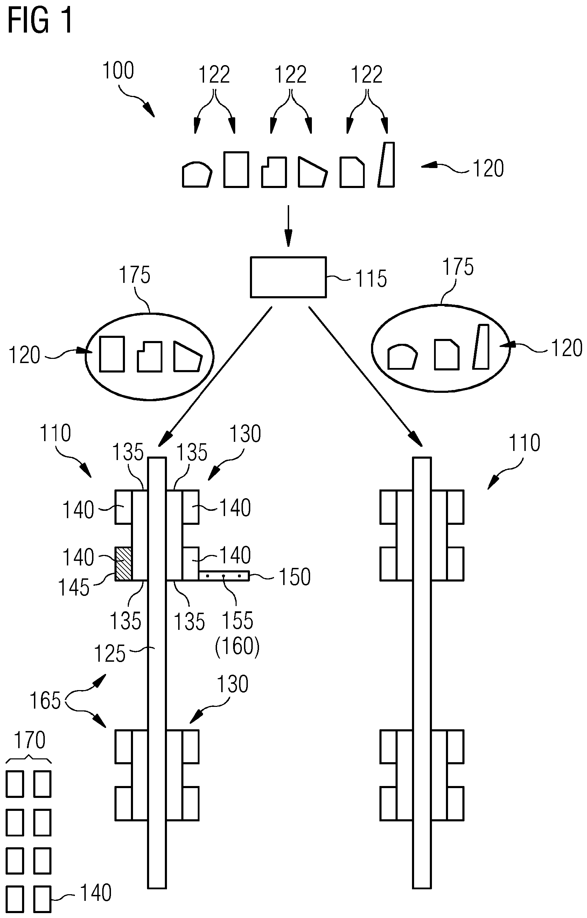

Figur 1 zeigt ein beispielhaftes Bestückungssystem 100. Das Bestückungssystem 100 umfasst eine oder mehrere Bestückungslinien 110 und eine Verarbeitungs- oder Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einer vorbestimmten Position auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementetypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementetyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementetyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-10 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementetypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementetypen 160 und wird realisiert durch einen oder mehrere Rüsttische 140, die mit Vorräten von Bauelementen 155 der Bauelementetypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementetypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden, wobei eine Festrüstung 165 dazu vorgesehen ist, auf einer Anzahl Wechseltische 140 über einen vorbestimmten Planungshorizont unverändert gerüstet zu bleiben, während ein Wechseltisch 140 einer Variantenrüstung 170 voraussichtlich innerhalb des Planungshorizonts mit Bauelementen 155 anderer Bauelementetypen 160 umgerüstet wird. Der Planungshorizont kann beispielsweise 6 bis 12 Monate betragen. Eine Variantenrüstung 165 besteht in einer vorbestimmten Konstellation üblicherweise wesentlich kürzer als der Planungshorizont, beispielsweise über mehrere Stunden oder Tage, üblicherweise jedoch nicht über mehr als eine Woche.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementetypen 160 aufgerüstet. Bereits aufgerüstete Bauelemente 155 nicht benötigter Bauelementetypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren wird versucht in den Festrüstungen 165 möglichst viele Leiterplattentypen 122 aufzunehmen. Ein angestrebter Fall ohne Variantenrüstungen 170 ist in der Praxis jedoch kaum erzielbar.

Erfindungsmäß kann ein konstanter Rüsttisch 145 gebildet werden, der in unterschiedlichen Rüstungen 165, 170 Verwendung findet, sodass er bei einem Rüstwechsel an der Bestückungslinie 115 unverändert gerüstet bleiben kann. Anders ausgedrückt unterscheidet sich ein konstanter Rüsttisch 145 von einem nicht konstanten Rüsttisch 140 dadurch, dass er bei einem Rüstungswechsel von einer Rüstung 165, 170 auf eine andere Rüstung 165, 170 unverändert bleibt. An Stelle eines üblichen, beweglichen Rüsttischs 140 kann als konstanter Rüsttisch 145 ein kostengünstigerer unbeweglicher Rüsttisch eingesetzt werden. Ein konstanter Rüsttisch 145 umfasst üblicherweise Bauelemente 155 von Bauelementetypen 160, die an den zu bestückenden Leiterplattentypen 122 sehr weit verbreitet sind, beispielsweise 100nF-Kondensatoren oder 0Ω-Widerstände.

Die Steuereinrichtung 115 ordnet im Rahmen der Steuerung des Bestückungssystems 100 Leiterplattentypen 122, deren zugeordnete Leiterplatten 120 auf der Bestückungslinie 110 bestückt werden sollen, jeweils einer Rüstfamilie 175 zu, wobei Festrüstungs-Rüstfamilien 175, die jeweils einer Festrüstung 165 zugeordnet ist, und Variantenrüstungs-Rüstfamilien 175, die jeweils einer Variantenrüstung 170 zugeordnet sind, gebildet werden können. Es wird angestrebt, die Rüstfamilien 175 derart zu bilden, dass die zugeordneten Rüstungen 165, 170 so realisiert werden können, dass Bauelemente 155 möglichst vieler Bauelementetypen 160 auf einem oder mehreren konstanten Rüsttischen 145 gehalten werden können. Diese Vorgehensweise ist insbesondere bei der Variantenfertigung vorteilhaft, bei der keine Festrüstung 165 verwendet werden kann.

In der Praxis kann beispielsweise für eine vorgegebene Produktionsmenge von Leiterplattentypen 122 in einem ersten Schritt eine Festrüstung 165 für einen (möglichst großen) Teil der Leiterplattentypen 122 gebildet werden, worauf in einem zweiten Schritt für den verbleibenden Teil der Leiterplattentypen 122 Variantenrüstungen 170 derart gebildet werden, dass sie mittels eines oder mehrerer konstanter Rüsttische 145, die Bauelemente 155 möglichst vieler Bauelementetypen 160 aufnehmen, realisiert werden können. Die beiden Schritte können auch nebenläufig oder integriert durchgeführt werden. Die Qualität der Optimierung dieser Zuordnungen entscheidet in hohem Maß darüber, wie gut die Produktionsmittel des Bestückungssystems 100 ausgelastet werden können und wie effizient dabei bestückt werden kann.

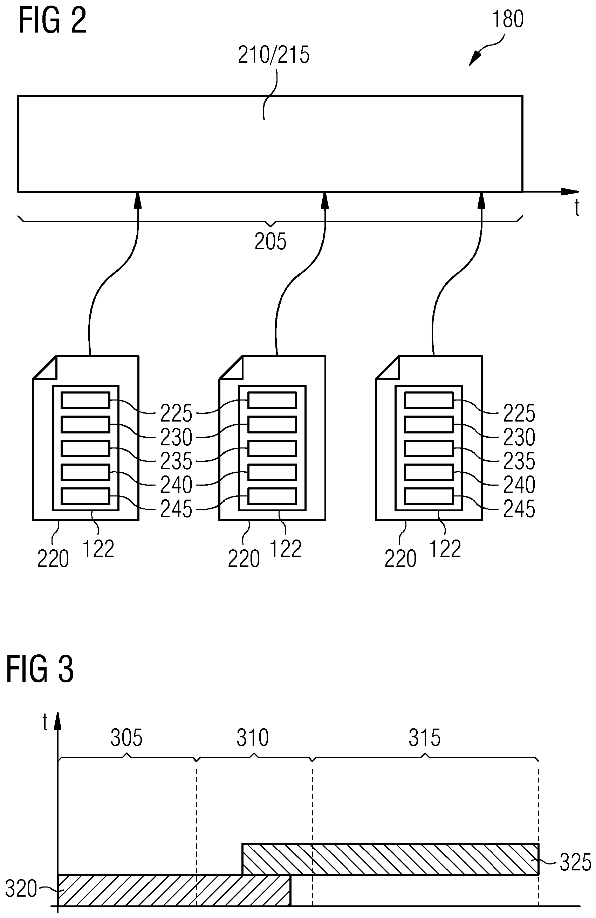

Figur 2 zeigt eine Veranschaulichung beispielhafter Rüstfamilien 175 an einer Bestückungslinie 110 aus Figur 1. Die Rüstfamilien 175 werden hier in eine Festrüstungs-Rüstfamilie 210, die einer Festrüstung 165 zugeordnet ist, und eine Variantenfertigungs-Rüstfamilie 215, die einer Variantenrüstung 170 zugeordnet ist, unterschieden. Innerhalb eines Planungshorizonts 205 können an der Bestückungslinie 110 im dargestellten Beispiel Leiterplattentypen 122 einer einzigen Festrüstungs-Rüstfamilie 210 oder einer einzigen Variantenfertigungs-Rüstfamilie 215 bestückt werden.

Es wird davon ausgegangen, dass zu Beginn des Planungshorizonts 205 mehrere Aufträge 220 vorliegen, die möglichst effizient auszuführen sind. Die Zahl der Aufträge wird Auftragszahl genannt. Jeder Auftrag 220 umfasst wenigstens einen Leiterplattentyp 122 und eine Stückzahl 225 zu bestückender Leiterplatten 120. Dem Leiterplattentyp 122 sind Bauelementetypen 160 zugeordnet, von denen Bauelemente 155 auf den einzelnen Leiterplatten 120 zu bestücken sind.

Einem Leiterplattentyp 122 können weitere Informationen zugeordnet sein. Beispielsweise können eine Anzahl 230 von Bauelementetypen 160, die auf jeder Leiterplatte 120 bestückt werden sollen, eine Anzahl 235 von Bestückpositionen einer Leiterplatte 120 oder eine Produktionszeit 240 für eine Leiterplatte 120, jeweils des Leiterplattentyps 122, angegeben sein. Die Anzahl der Bestückpositionen entspricht der Anzahl der auf einer Leiterplatte 120 des Leiterplattentyps 122 zu bestückenden Bauelemente 155, gleich welchen Bauelementetyps 160. Ferner kann eine Auftragszahl 245 angegeben sein, die angibt, wie viele Aufträge 220 zur Bestückung von Leiterplatten 120 eines Leiterplattentyps 122 in einem vorbestimmten Planungshorizont 205 vorliegen.

Durch den Einsatz von mathematischen Verfahren lassen sich für die Zuordnung von Leiterplattentypen 122 zu Rüstfamilien 175 deutlich bessere Lösungen erzielen als mit bisher in der Praxis verwendeten Vorgehensweisen. Zur Bestimmung einer optimierten Zuordnung von Leiterplattentypen 122 zu einer Festrüstungs-Rüstfamilie 210 kann außerdem eine automatische Optimierung verwendet werden, die von einer initialen Zuordnung ausgehen kann.

Zur Optimierung können unterschiedliche Verfahren verwendet werden, beispielsweise auf der Basis von lokalen Suchverfahren oder metaheuristischen Algorithmen. Bevorzugterweise wird jedoch ein IP-Modell (Integer Programmierung bzw. Integer Programm oder Gemischt Ganzzahliges Optimierungsmodell) verwendet. Eines der Hauptverfahren auf dem Gebiet der mathematischen Optimierung ist die Lineare Optimierung, die sich mit der Optimierung linearer Zielfunktionen über einer Menge befasst, die durch lineare Gleichungen und Ungleichungen eingeschränkt ist. Die Lineare Optimierung ist die Grundlage der Lösungsverfahren der (Gemischt) Ganzzahligen Linearen Optimierung.

Vorteile der Linearen Optimierung:

- Globaler Optimierungsansatz
- Leicht erweiterbar
- Sehr gute kommerzielle Standard-Solver (Ilog, Gurobi, Xpress), die in der Praxis weit verbreitet und bewährt sind
- Für eine ermittelte Lösung ist bekannt, wie weit sie maximal von der optimalen Lösung entfernt ist (Gap).

Im Folgenden werden Beispiele für IP-Formulierungen zur Optimierung der beschriebenen Zuordnung von Leiterplattentypen 122 zu Rüstfamilien 175 gegeben.

Indices

C        Menge der Bauelementetypen
R        Menge der Leiterplattentypen
Rc       Menge der Leiterplattentypen mit Bauelementetyp c
F        Menge der Rüstfamilien

Parameter

$Width_c$        Platzverbrauch (in Spuren) eines Bauelementetyps c
**CapVar**        Platzkapazität (in Spuren) der nicht konstanten Rüsttische 140
**CapConst**        Platzkapazität (in Spuren) der konstanten Rüsttische 145
$Order_r$        Anzahl Aufträge für Leiterplatten des Leiterplattentyps r

Binärvariablen

$Assign_{r,f}$        hat den Wert 1, falls ein Leiterplattentyp r der Festrüstungs-Rüstfamilie f zugeordnet wird, andernfalls den Wert 0.

$Setup_{c,f}$        hat den Wert 1, falls der Bauelementetyp c in der Rüstung der Festrüstungs-Rüstfamilie f gerüstet werden muss, ansonsten den Wert 0.

$SetupFixed_c$        hat den Wert 1, falls der Bauelementetyp c in mindestens einer Festrüstung 165 gerüstet werden muss, ansonsten den Wert 0.

$SetupConst_c$        hat den Wert 1, falls der Bauelementetyp c auf einem konstanten Rüsttisch 140 gerüstet werden muss, ansonsten den Wert 0.

$SetupVar_{c,f}$        hat den Wert 1, falls der Bauelementetyp c in der Rüstung der Festrüstungs-Rüstfamilie f auf den nicht konstanten Rüsttischen 140 gerüstet werden muss, andernfalls den Wert 0.

IP Formulierung

Die Optimierung kann bezüglich der Stückzahl 225 der Aufträge 220 zur Bestückung von Leiterplatten 120 bestimmter Leiterplattentypen 122 erfolgen. Es kann also versucht werden, Festrüstungen 165 zu finden, mit denen möglichst viele Leiterplatten 120 bestückt werden können.

Es wird vorgeschlagen, die Zuordnung bzw. deren Optimierung derart durchzuführen, dass sicher gestellt ist, dass sich wenigstens ein konstanter Rüsttisch 145 bilden lässt. Dabei ist der konstante Rüsttisch 145 von einer oder mehreren Festrüstungen 165 umfasst, bevorzugterweise von allen Festrüstungen. Die Zahl der konstanten Rüsttische 145, die gebildet werden sollen, kann bevorzugterweise vorgegeben werden.

Die folgende Ausdrucksweise bezieht sich auf eine MIP (Mixed Integer Linear Program), das beispielsweise mittels eines Standard-Solvers ausgeführt werden kann:

$$maximize \sum_{r \in R} \sum_{f \in F} Order_r \, Assign_{r,f}$$

Bei einer Optimierung mittels MIP können eine oder mehrere Randbedingungen vorgegeben werden, die die Bildung der konstanten Rüsttische 140 garantieren können:

(1)

$$\sum_{f \in F} Assign_{r,f} \leq 1 \qquad\qquad r \epsilon R$$

(2)

$$\sum_{r \in R_c} Assign_{r,f} \leq |R_c| Setup_{c,f} \qquad\qquad c \epsilon C; f \epsilon F$$

(3)

$$Setup_{c,f} \leq SetupConst_c + SetupVar_{c,f} \qquad\qquad c \epsilon C; f \epsilon F$$

(4)

$$\sum_{c \in C} Width_c \, SetupVar_{c,f} \leq CapVar \qquad\qquad f \epsilon F$$

(5)

$$\sum_{c \in C} Width_c \, SetupConst_c \leq CapConst$$

$$Setup_{c,f} \in \{0,1\} \qquad\qquad c \epsilon C; f \epsilon F$$

$$SetupConst_c \in \{0,1\} \qquad\qquad c \epsilon C$$

$$SetupVar_{c,f} \in \{0,1\} \qquad\qquad c \epsilon C; f \epsilon F$$

$$Assign_{r,f} \in \{0,1\} \qquad\qquad r \epsilon R; f \epsilon F$$

Zu diesen Bedingungen gelten folgende Erläuterungen:

Zu (1): Jeder Leiterplattentyp 122 darf höchstens einer Festrüstung 165 zugewiesen werden.

Zu (2): Ein Bauelementetyp 122 muss in einer Festrüstung f gehalten werden, wenn dieser Festrüstung 165 mindestens ein Leiterplattentyp 122 zugewiesen ist, dem dieser Bauelementetyp 122 zugewiesen ist.

Zu (3): Ist ein Bauelementetyp 122 in einer Festrüstung 165, so muss er entweder auf den konstanten Rüsttischen 145 oder auf den nicht konstanten Rüsttischen 140 der Rüstung stehen.

Zu (4): Die Platzkapazitäten der nicht konstanten Rüsttische 140 einer Festrüstung 165 müssen eingehalten werden.

Zu (5): Die Platzkapazitäten der konstanten Rüsttische 145 müssen eingehalten werden.

In einem Spezialfall, der in der Praxis häufig anzutreffen ist, sind zwei Festrüstungs-Rüstfamilien 210 vorgesehen. Jeder Rüstfamilie 175 ist eine Festrüstung 165, 170 eineindeutig zugeordnet. In diesem Fall kann die Optimierung mit den unten angegebenen Randbedingungen deutlich schneller durchgeführt werden als mit der oben angegebenen allgemeinen Formulierung des Optimierungsproblems. Dadurch kann ein Geschwindigkeitsvorteil im Bereich von einem Faktor von ca. 10 erreicht werden:

$$maximize \sum_{r \in R} \sum_{f \in F} Order_r\ Assign_{r,f}$$

Die Randbedingungen lauten:

(1)

$$\sum_{f \in F} Assign_{r,f} \leq 1 \qquad\qquad r \epsilon R$$

(2)

$$\sum_{r \in R_c} Assign_{r,f} \leq |R_c| Setup_{c,f} \qquad\qquad c \epsilon C; f \epsilon F$$

(3)

$$\sum_{c \in C} Width_c Setup_{c,f} \leq CapVar + CapConst \qquad\qquad f \epsilon F$$

(4)

$$\sum_{f \in F} Setup_{c,f} \leq 2\ SetupFixed_c \qquad\qquad c \epsilon C$$

(5)

$$\sum_{f \in F} Setup_{c,f} \geq SetupFixed_c \qquad\qquad c\epsilon C$$

(6)

$$\sum_{c \in C} Width_c\, SetupFixed_c \leq 2\, CapVar + CapConst$$

$$Setup_{c,f} \in \{0,1\} \qquad\qquad c\epsilon C;\, f\epsilon F$$

$$SetupFixed_c \in \{0,1\} \qquad\qquad c\epsilon C$$

$$Assign_{r,f} \in \{0,1\} \qquad\qquad r\epsilon R;\, f\epsilon F$$

Zu diesen Bedingungen gelten folgende Erläuterungen:

Zu (1): Jeder Leiterplattentyp 122 darf höchstens einer Festrüstung 165 zugewiesen werden.

Zu (2): Ein Bauelementetyp 160 muss in einer Festrüstung f gehalten werden, wenn dieser Festrüstung 165 mindestens ein Leiterplattentyp 122 zugewiesen ist, dem dieser Bauelementetyp 160 zugewiesen ist.

Zu (3): Die Platzverbräuche der Festrüstungen 165 dürfen die Linienkapazitäten nicht überschreiten. Die Linienkapazität der Bestückungslinie 110 gibt an, wie viel Platz für Bauelemente 155 unterschiedlicher Bauelementetypen 160 zur Verfügung steht. Die Linienkapazität wird üblicherweise in Spuren ausgedrückt.

Zu (4): Ist ein Bauelementetyp 160 in einer Festrüstung 165, so gehört er zur Bauelementetypmenge der Festrüstungen 165.

Zu (5): Ist ein Bauelementetyp 160 in der Bauelementtypmenge der Festrüstungen 165, so ist er in mindestens einer Festrüstung 165.

Zu (6): Die Summe der Platzverbräuche der Bauelementetypen 160 der beiden Festrüstungen 165 darf die für sie zur Verfügung stehende Linienkapazität nicht überschreiten. Diese entspricht der doppelten Linienkapazität der nicht konstanten Rüsttische 140 zuzüglich der Linienkapazität der konstanten Rüsttische 145, da sich beide Festrüstungen 165 die konstanten Rüsttische 145 teilen.

Figur 3 zeigt Rüstungen 320, 325 für einen Bestückungsautomaten 110. In horizontaler Richtung sind Spuren des Bestückungsautomaten 130 bzw. von zur Verfügung stehenden Rüsttischen 140, in vertikaler Richtung zeitlich aufeinander folgende Rüstungen 320, 325 dargestellt. Die Darstellung gilt sinngemäß auch für eine Bestückungslinie 110 mit mehreren Bestückungsautomaten 130. Die Spuren sind in drei Abschnitte 305, 310 und 315 aufgeteilt, wobei die Abschnitte 305 und 315 der Kapazität der nicht konstanten Rüsttische und der Abschnitt 310 der Kapazität der konstanten Rüsttische 145 entspricht. Eine erste Festrüstung 320 belegt Spuren aus den Abschnitten 305 und 310; eine zweite Festrüstung 325 Spuren aus den Abschnitten 310 und 315. Bauelementtypen 160, die in der Darstellung vertikal übereinander stehen, sind gleich. Bauelemente 155 der Bauelementtypen 160 des mittleren Abschnitts 310 können auf einem konstanten Rüsttisch 145 gerüstet werden, der beim Übergang von der ersten Festrüstung 320 auf die zweite Festrüstung 325 nicht ausgewechselt werden muss. Bauelemente 155 der Bauelementtypen 160, die in den Abschnitten 305 und 315 liegen, können auf unterschiedlichen Rüsttischen 140 gerüstet werden. Hier sind die Bauelementtypen 160 disjunkt, sodass der Rüsttisch 140 des ersten Abschnitts 305 beim Rüstwechsel von der ersten Festrüstung 320 zur zweiten Festrüstung 325 gegen den des zweiten Abschnitts 315 an der Bestückungslinie 110 ausgetauscht werden kann. Diese Vorgehensweise kann auch mit Variantenrüstungen 170 oder zwischen einer Festrüstung 165 und einer Variantenrüstung 165 angewendet werden.

Das vorgestellte Verfahren, das durch die obigen beispielhaften MIP-Formulierungen ausgedrückt ist, lässt sich leicht an andere Zielvorgaben bzw. ein anderes zu optimierendes Zielkriterium anpassen. Beispielsweise kann statt der Auftragszahl das Bestückvolumen optimiert werden. Dazu muss in einer der oben angegebenen Bedingungen lediglich *order,* durch **BestückVolumen,** ersetzt werden.

Es können auch alternative oder zusätzliche Bedingungen für die Optimierung angegeben sein. Beispielsweise kann gefordert sein, dass eine Teilmenge der Leiterplattentypen 122 der selben Rüstfamilie 210, 215 zugeordnet werden muss, etwa um jeweils eine Vorderseite und eine Rückseite der zugeordneten Leiterplatten 120 zu bestücken.

Nach Abschluss der Bestimmung der Festrüstungen 165 und der Aufteilung der Bauelementetypen 160 der einzelnen Festrüstungen 165 auf konstante Rüsttische 145 und Rüsttische 140 kann die Bestückung mit einer der Rüstungen 165, 170 auf der Bestückungslinie 110 durchgeführt werden. Der Vorgang des Bestückens kann ebenfalls durch die Steuereinrichtung 115 oder durch eine andere Steuereinrichtung gesteuert werden.

Obwohl die Erfindung im Detail durch das bevorzugte Ausführungsbeispiel näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Zuordnen von Leiterplattentypen (122)

    - auf einer Bestückungslinie (110),
    - wobei Rüstfamilien (175) mit zugehörigen Rüstungen (165, 170) vorgesehen sind;
    - wobei jeder Rüstfamilie (175) eine Anzahl Leiterplattentypen (122) und jeder zugeordneten Rüstung (165, 170) eine Anzahl Bauelementetypen (160) zugeordnet ist,
    - sodass eine Leiterplatte (120) eines Leiterplattentyps (122) einer Rüstfamilie (175) mittels Bauelementen der Bauelementetypen (160) der Rüstung (165, 170) an der Bestückungslinie bestückt werden kann;
    - wobei Vorräte von Bauelementen der Bauelementtypen einer Rüstung (165, 170) mittels Rüsttischen (140) an der Bestückungslinie (110) bereitgestellt werden können,

    wobei das Verfahren folgende Schritte umfasst:

    - Erfassen von Leiterplattentypen (122), von denen Leiterplatten (120) mit Bauelementen (155) zugeordneter Bauelementetypen (160) bestückt werden sollen;
    - Zuordnen von erfassten Leiterplattentypen (122) zu einer vorgegebenen Anzahl von Festrüstungs-Rüstfamilien (175), wobei den Festrüstungs-Rüstfamilien (175) jeweils eine Festrüstung (165) zugeordnet ist, wobei eine Festrüstung (165) auf einer Anzahl Wechseltische (140) über einen vorbestimmten Planungshorizont unverändert gerüstet bleibt,
    - Optimieren der Zuordnung bezüglich eines vorbestimmten Kriteriums,
    - wobei jedem Leiterplattentyp (122) eine Stückzahl von zu bestückenden Leiterplatten (120) und eine Bestückzeit, die zur Bestückung einer Leiterplatte (120) des Leiterplattentyps (122) auf der Bestückungslinie (110) erforderlich ist, zugeordnet ist und das Kriterium umfasst, die Bestückzeit, die zur Bestückung aller Leiterplatten (120) aller zugeordneten Leiterplattentypen (122) erforderlich ist, möglichst zu maximieren, wobei
    - das Optimieren derart erfolgt, dass die Bauelementtypen der Festrüstungen (165, 170) aller Festrüstungs-Rüstfamilien (175) so auf Rüsttische (140) aufgeteilt werden können, dass eine wenigstens eins betragende Anzahl konstanter Rüsttische (145), welche bei einem Rüstwechsel unverändert gerüstet bleiben können, über alle Rüstungen (165, 170) an der Bestückungslinie (110) verbleiben kann,
    - Bereitstellen einer der Festrüstungen (165) an der Bestückungslinie (110).

2. Verfahren nach Anspruch 1, wobei genau zwei Festrüstungen (165, 170) vorgesehen sind.

3. Verfahren nach einem der vorangehenden Ansprüche, wobei das Optimieren mittels Gemischt Ganzzahliger Programmierung erfolgt.

4. Verfahren nach einem der vorangehenden Ansprüche, wobei das Zuordnen derart erfolgt, dass ein Platzverbrauch der Bauelementetypen (160), die im Rahmen der bestimmten Rüstung (165, 170) einer Bestückungslinie (110) zugeordnet sind, einen vorbestimmten Anteil eines zur Verfügung stehenden Platzes einhält.

5. System (100) zur Bestückung von Leiterplatten (120)

- eine Bestückungslinie (110) und

- eine Verarbeitungseinrichtung (115) zur Zuordnung von erfassten Leiterplattentypen (122), deren zugeordnete Leiterplatten (120) auf der Bestückungslinie (110) bestückt werden sollen, zu einer vorgegebenen Anzahl von Festrüstungs-Rüstfamilien (175) nach einem Verfahren nach einem der vorangehenden Ansprüche.

**Claims**

1. Method for assigning printed circuit board types (122)

   - on a pick-and-place line (110),
   - set-up families (175) with associated set-ups (165, 170) being provided;
   - a number of printed circuit board types (122) being assigned to each set-up family (175) and a number of component types (160) being assigned to each associated set-up (165, 170),
   - with the result that a printed circuit board (120) of a printed circuit board type (122) in a set-up family (175) can be populated by means of components of the component types (160) in the set-up (165, 170) on the pick-and-place line;
   - stocks of components of the component types in a set-up (165, 170) being able to be provided by means of set-up tables (140) on the pick-and-place line (110),

   the method comprising the following steps of:

   - detecting printed circuit board types (122), printed circuit boards (120) of which are intended to be populated with components (155) of associated component types (160);
   - assigning detected printed circuit board types (122) to a predefined number of set-up families (175) of the fixed set-up type, a fixed set-up (165) being assigned to each of the set-up families (175) of the fixed set-up type, a fixed set-up (165) remaining with an unchanged set-up on a number of shuttle tables (140) over a predetermined planning horizon,
   - optimizing the assignment with respect to a predetermined criterion,
   - a quantity of printed circuit boards (120) to be populated and a population time which is needed to populate a printed circuit board (120) of the printed circuit board type (122) on the pick-and-place line (110) being assigned to each printed circuit board type (122), and the criterion comprising maximizing the population time, which is needed to populate all printed circuit boards (120) of all associated printed circuit board types (122), as far as possible,
   - the optimization being carried out in such a manner that the component types in the fixed set-ups (165, 170) of all set-up families (175) of the fixed set-up type can be divided among set-up tables (140) such that a number, which is at least one, of constant set-up tables (145) that can remain with an unchanged set-up during a set-up change can remain on the pick-and-place line (110) over all set-ups (165, 170),
   - providing one of the fixed set-ups (165) on the pick-and-place line (110).

2. Method according to Claim 1, exactly two fixed set-ups (165, 170) being provided.

3. Method according to one of the preceding claims, the optimization being carried out by means of mixed integer programming.

4. Method according to one of the preceding claims, the assignment being carried out in such a manner that a space used by the component types (160), which are assigned to a pick-and-place line (110) within the scope of the particular set-up (165, 170), complies with a predetermined portion of an available space.

5. System (100) for populating printed circuit boards (120), comprising

   - a pick-and-place line (110), and
   - a processing device (115) for assigning detected printed circuit board types (122), the associated printed circuit boards (120) of which are intended to be populated on the pick-and-place line (110), to a predefined number of set-up families (175) of the fixed set-up type in accordance with a method according to one of the preceding claims.

**Revendications**

1. Procédé permettant d'associer des types de cartes de circuit imprimé (122)

- sur une chaîne de montage (110),
- dans lequel des familles d'équipement (175) avec des équipements correspondants (165, 170) sont prévues ;
- dans lequel à chaque famille d'équipement (175) est associé un nombre de types de cartes de circuit imprimé (122) et à chaque équipement (165, 170) associé est associé un nombre de type de composants (160),
- de sorte qu'une carte de circuit imprimé (120) d'un type de carte de circuit imprimé (122) d'une famille d'équipement (175) peut être montée au moyen de composants des types de composants (160) de l'équipement (165, 170) au niveau de la chaîne de montage ;
- dans lequel des stocks de composants des types de composants d'un équipement (165, 170) peuvent être mis à disposition au moyen de tables d'équipement (140) au niveau de la chaîne de montage (110),

dans lequel le procédé comprend les étapes suivantes :

- acquisition de types de cartes de circuit imprimé (122) dont des cartes de circuit imprimé (120) doivent être équipées de composants (155) de types de composants (160) associés ;
- association de types de cartes de circuit imprimé (122) acquis à un nombre prédéterminé de familles d'équipement en équipement fixe (175), dans lequel un équipement fixe (165) est respectivement associé aux familles d'équipement en équipement fixe (175), dans lequel un équipement fixe (165) reste équipé de manière inchangée sur un nombre de tables alternantes (140) par le biais d'un horizon de planification prédéterminé,
- optimisation de l'association en ce qui concerne un critère prédéterminé,
- dans lequel à chaque type de carte de circuit imprimé (122) est associé un nombre de pièces de cartes de circuit imprimé à équiper (120) et un temps de montage qui est nécessaire au montage d'une carte de circuit imprimé (120) du type de carte de circuit imprimé (122) sur la chaîne de montage (110) et comprend le critère pour maximiser le plus possible le temps de montage qui est nécessaire au montage de toutes les cartes de circuit imprimé (120) de tous les types de cartes de circuit imprimé (122) associés,
- dans lequel l'optimisation se produit de telle sorte que les types de composant des équipements fixes (165, 170) de toutes les familles d'équipement en équipement fixe (175) peuvent être répartis sur des tables d'équipement (140) de sorte qu'un nombre d'au moins un de tables d'équipement constantes (145), qui peuvent rester équipées de manière inchangée lors d'un changement d'équipement, peuvent rester au niveau de la chaîne de montage (110) sur tous les équipements (165, 170),
- mise à disposition d'un des équipements fixes (165) au niveau de la chaîne de montage (110).

2. Procédé selon la revendication 1, dans lequel exactement deux équipements fixes (165, 170) sont prévus.

3. Procédé selon l'une quelconque des revendications précédentes, dans lequel l'optimisation se produit au moyen d'une programmation mixte en nombres entiers.

4. Procédé selon l'une quelconque des revendications précédentes, dans lequel l'association se produit de telle sorte qu'un encombrement des types de composant (160) qui sont associés à une chaîne de montage (110) dans le cadre de l'équipement (165, 170) concerné respecte une part prédéterminée d'un espace disponible.

5. Système (100) permettant de monter des cartes de circuit imprimé (120)

- une chaîne de montage (110) et
- un dispositif de traitement (115) permettant une association de types de cartes de circuit imprimé (122) acquis, dont des cartes de circuit imprimé (120) associées doivent être montées sur la chaîne de montage (110), à un nombre prédéterminé de familles d'équipement en équipement fixe (175) selon un procédé selon l'une quelconque des revendications précédentes.

FIG 1

# FIG 2

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012220904 A1
- EP 0478360 A1

- DE 102009013353